# EUROPÄISCHE PATENTSCHRIFT

(11) **EP 1 601 813 B1**
(45) Veröffentlichungstag und Bekanntmachung des Hinweises auf die Patenterteilung: **06.08.2008**
(21) Anmeldenummer: 04703337.8
(22) Anmeldetag: 20.01.2004
(51) Int. Cl.: C23C 16/24, H01L 31/18, C23C 16/505

(54) **VERFAHREN ZUR ABSCHEIDUNG VON SILIZIUM**
METHOD FOR DEPOSITING SILICON
PROCEDE DE DEPOT DE SILICIUM

(30) Priorität: 27.02.2003 DE 10308381
(43) Veröffentlichungstag der Anmeldung: 07.12.2005
(73) Patentinhaber: Forschungszentrum Jülich GmbH, 52425 Jülich (DE)
(72) Erfinder: ROSCHEK, Tobias, CH-9470 Buchs SG (CH); RECH, Bernd, 52070 Aachen (DE)
(86) Internationale Anmeldenummer: PCT/DE2004/000066
(87) Internationale Veröffentlichungsnummer: WO 2004/076713

(56) Entgegenhaltungen:
- US-A- 5 334 423
- RECH B ET AL: "New materials and deposition techniques for highly efficient silicon thin film solar cells" SOLAR ENERGY MATERIALS AND SOLAR CELLS, ELSEVIER SCIENCE PUBLISHERS, AMSTERDAM, NL, Bd. 74, Nr. 1-4, Oktober 2002 (2002-10), Seiten 439-447, XP004376973 ISSN: 0927-0248
- REPMANN T ET AL: "DEVELOPMENT OF A-Si:H/μc-Si:H THIN FILM SOLAR MODULES USING 13.56 MHz PECVD" , 17TH. E.C. PHOTOVOLTAIC SOLAR ENERGY CONFERENCE. MUNICH, GERMANY, OCT. 22 - 26, 2001, PROCEEDINGS OF THE INTERNATIONAL PHOTOVOLTAIC SOLAR ENERGY CONFERENCE, MUNICH: WIP-RENEWABLE ENERGIES, DE, VOL. VOL. 3 OF 3. CONF. 17, PAGE(S) 2836-2841 XP001140079 ISBN: 3-936338-08-6 Seite 2837; Abbildungen 2,3
- RECH B ET AL: "Amorphous and microcrystalline silicon solar cells prepared at high deposition rates using RF (13.56MHz) plasma excitation frequencies" SOLAR ENERGY MATERIALS AND SOLAR CELLS, ELSEVIER SCIENCE PUBLISHERS, AMSTERDAM, NL, Bd. 66, Nr. 1-4, Februar 2001 (2001-02), Seiten 267-273, XP004224685 ISSN: 0927-0248
- FEITKNECHT L ET AL: "Microcrystalline n-i-p solar cells deposited at 10 ?9/s by VHF-GD" SOLAR ENERGY MATERIALS AND SOLAR CELLS, ELSEVIER SCIENCE PUBLISHERS, AMSTERDAM, NL, Bd. 66, Nr. 1-4, Februar 2001 (2001-02), Seiten 397-403, XP004224702 ISSN: 0927-0248
- DENG X ET AL: "VHF PLASMA DEPOSTION OF MUC-SI P-LAYER MATERIALS" , AMORPHOUS AND MICROCRYSTALLINE SILICON TECHNOLOGY - 1997. SAN FRANCISCO, CA, MARCH 31 - APRIL 4, 1997, MATERIALS RESEARCH SOCIETY SYMPOSIUM PROCEEDINGS. VOL. 467, PITTSBURGH, PA: MRS, US, VOL. VOL. 467, PAGE(S) 795-800 XP000905783 ISBN: 1-55899-371-1 Zusammenfassung; Tabelle 1
- SCHROPP R E I ET AL: "NOVEL PROFILED THIN-FILM POLYCRYSTALLINE SILICON SOLAR CELL ON STAINLESS STEEL SUBSTRATES" IEEE TRANSACTIONS ON ELECTRON DEVICES, IEEE INC. NEW YORK, US, Bd. 46, Nr. 10, Oktober 1999 (1999-10), Seiten 2069-2071, XP000869357 ISSN: 0018-9383
- FEITKNECHT L ET AL: "Plasma deposition of thin film silicon: kinetics monitored by optical emission spectroscopy" SOLAR ENERGY MATERIALS AND SOLAR CELLS, ELSEVIER SCIENCE PUBLISHERS, AMSTERDAM, NL, Bd. 74, Nr. 1-4, Oktober 2002 (2002-10), Seiten 539-545, XP004376985 ISSN: 0927-0248

## Beschreibung

Die Erfindung betrifft ein Verfahren zur Abscheidung von mikrokristallinem Silizium, bei dem nur wenig Wasserstoff benötigt wird.

### Stand der Technik

Mikrokristallines Silizium ist ein Material, welches insbesondere in Solarzellen als Absorbermaterial genutzt wird. Es wird heute in vielen Labors mittels des PECVD-Verfahrens (plasma enhanced chemical vapor deposition) aus Silan und Wasserstoff hergestellt. Die Zugabe von Wasserstoff, die sogenannte Wasserstoffverdünnung, ist dabei notwendig um kristallines Silizium bei Substrattemperaturen unter 500°C herzustellen. Diese kristallinen Siliziumschichten bestehen aus vielen mikroskopisch kleinen Kristalliten - daher der Name mikrokristallines Silizium.

Es können in verschiedenen Depositionsregimen qualitativ hochwertige Schichten aus mikrokristallinem Silizium abgeschieden werden. Bei der Abscheidung mit PECVD bei der Standardindustriefrequenz 13,56 MHz beträgt die Silankonzentration (=Silanfluss/Wasserstofffluss) typischerweise ca. 1 %, bei Anregungsfrequenzen im VHF-Bereich in der Regel weniger als 10%. Der Wasserstoff wird benötigt um das Schichtwachstum zu beeinflussen. Es wird jedoch nur ein geringer Teil des eingesetzten Wasserstoffs in die hergestellte Siliziumschicht eingebaut, typischerweise weniger als 10 %. Der übrige Wasserstoff wird abgepumpt. Für eine spätere industrielle Produktion ist der hohe Wasserstoffverbrauch, insbesondere bei Abscheidung bei 13,56 MHz, aufgrund der hohen Kosten ein ernsthaftes Problem^{[1]}.

Aus dem Stand der Technik sind inzwischen die folgenden verbesserten Methoden zur Abscheidung von mikrokristallinem Silizium mittels PECVD mit geringem Wasserstoffverbrauch bekannt.

### 1. Das "Closed-chamber CVD Verfahren" (CC-CVD)^{[2]}:

Dieser untersuchte Prozess verläuft zyklisch (diskontinuierlich) und umfasst im wesentlichen zwei Prozessschritte. In einem ersten Schritt fließt eine geringe Menge des reaktiven Prozessgas (SiH₄ oder eine CH₄/SiH₄-Mischung) in einem Verhältnis von ca. 25 % reaktivem Gas zu Wasserstoff durch die Kammer. Dieser Schritt dient der Auffrischung der Gasatmosphäre nach einem Prozesszyklus. Während dieser Zeit brennt das Plasma bei geringer Leistung (ca. 10 W), so dass eine ultra dünne Siliziumschicht abgeschieden wird.

Im nachfolgenden zweiten Schritt wird sowohl die Pumpleistung aus der Kammer als auch die Gasversorgung in die Kammer unterbrochen. Durch eine Verzögerung des Abschaltens der Wasserstoffzufuhr wird der Depositionsdruck erhöht und die Silankonzentration auf -5 % erniedrigt. Das Plasma brennt nun bei ca. 60 W weiter. Die Prozessgase werden allmählich zersetzt und die abgeschiedene Schicht wächst weiter. Zur gleichen Zeit tritt ein gegensätzlicher Effekt auf. Die Schicht wird durch H-Radikale geätzt. Die Ätzrate nimmt aufgrund des steigenden Anteils an Wasserstoff im Plasma immer weiter zu, bis schließlich ein Gleichgewicht zwischen Schichtwachstum und Ätzen erreicht ist. Atome die schwach gebunden sind werden bevorzugt geätzt, so dass sich schließlich ein Netzwerk mit stärkeren Bindungen ausbildet.

Der gesamte Abscheidungsprozess erfolgt als ständige Abfolge dieser beiden Schritte (layer by layer) bis zur gewünschten Schichtdicke. Es wird von einem kristallinen Volumenanteil von mehr als 90 % berichtet. Durch die zyklische Veränderung der Prozessbedingungen ist dieser Prozess jedoch sehr aufwendig. Er unterscheidet sich grundsätzlich von dem standardmäßig eingesetzten PECVD-Verfahren, und ist bislang noch nicht für den Einsatz in der Industrie geeignet. Mit diesem Verfahren konnte bisher auch noch keine Solarzelle realisiert werden.

### 2. Das "Static closed chamber Verfahren" (VHFGD)^{[3]}:

Dieses "very high frequency glow discharge" (VHFGD) Abscheidungsverfahren ist ein kontinuierlicher Prozess ohne jegliche Einsatz von Wasserstoff. Die Depositionskammer (Plasmakammer) ist nicht vollständig isoliert. Ein geringer Silanfluss wird in die Kammer eingelassen und eine entsprechende Menge Gas wird gleichzeitig abgepumpt. Die Abscheidung erfolgt bei VHF-Anregung und bei niedrigem Druck (0,1 mbar). Bei der Abscheidung von Silizium aus Silan wird Wasserstoff frei. Der geringe Silangasfluss sorgt dafür, dass eine Silanverarmung auftritt. Die anfänglich schnelle Abscheidung des Siliziums wird durch die Zunahme an dissoziiertem Wasserstoff gebremst. Nach ca. einer Minute herrschen statische Bedingungen mit einem kleinen Verhältnis von [SiH^{*}]/[Hα] vor, bei denen ein kontinuierliches mikrokristallines Wachstum ermöglicht wird.

Da die Abscheidung mit einem reinen Silanplasma gestartet wird und erst später durch die Zersetzung des Silans Wasserstoff hinzukommt, weist die abgeschiedene Schicht eine ausgeprägte amorphe Inkubationsschicht (- 10 nm) als erste Schicht auf. Das kann bei dem Einsatz solcher Schichten in Bauelementen, insbesondere in Solarzellen, zu einer deutlichen Beeinträchtigung der Funktion führen. So konnte bei Solarzellen deren i-Schicht mit diesem Verfahren hergestellt wurden, nur ein Wirkungsgrad von 2,5 % erzielt werden.

Aus Rech et al. (B. Rech, O. Kluth, T. Repmann, T. Roschek, J. Springer, J. Müller, F. Finger, H. Stiebig, H. Wagner (2002). New materials and deposition techniques for highly efficient silicon thin film solar cells. Solar Energy Materials & Solar Cells 74 (2002) 439-447) ist ein PECVD-Verfahren für die Herstellung von µC-Si:H-Solarzellen bekannt.

Repmann et al. (T. Repmann, W. Appenzeller, T. Roschek, B. Rech, O. Kluth, J. Müller, (2001). Development of a-Si:H/µC-Si:H thin film solar mudules using 13.56 MHz PECVD. 17th Europaen Photovoltaic Solar Energy Conference, 22-26 October 2001, Munich, Germany, Seiten 2836-2841) offenbaren die Entwicklung von Dünnfilmsolarzellenmodulen mit a-Si:H/µC-Si:H-Schichten mittels eines PECVD-Verfahrens bei 13,56 MHz Anregungsfrequenz.

Aus Rech et al. (B. Rech, T. Roschek, J. Müller, S. Wieder, H. Wagner (2001). Amorphous and microcrystalline silicon solar cells prepared at high deposition rates using RF (13.56MHz) plasma excitation frequencies. Solar Energy Materials & Solar Cells 66 (2001) 267-273) ist ein weiteres Verfahren zur Abscheidung von mikrokristallinen und amorphen Silizium für Solarzellen bei hohen Depositionsraten bekannt.

Nachteilig sind auch bei diesen Verfahren nur geringe Wirkungsgrade von etwa 2,5% erhältlich oder aber die Schichten weisen keine ausreichend homogene Struktur auf.

### Aufgabe und Lösung

Aufgabe der Erfindung ist es, ein Verfahren zur Herstellung von mikrokristallinen Siliziumschichten bereit zu stellen, welches einerseits in Richtung des Schichtwachstums eine nahezu homogene mikrokristalline Struktur, d. h. homogene strukturelle Eigenschaften, aufweist und bei dem andererseits nur geringe Mengen an Wasserstoff eingesetzt werden.

Die Aufgabe wird gelöst durch ein Verfahren zur Herstellung von mikrokristallinen Siliziumschichten gemäß Hauptanspruch. Vorteilhafte Ausführungsformen des Verfahrens befinden sich in den jeweils darauf rückbezogenen Ansprüchen.

### Gegenstand der Erfindung

Die Bildung von homogenen mikrokristallinen Siliziumschichten insbesondere als eine erste Schicht auf einem Substrat in einer Plasmaabscheidekammer kann nur in Anwesenheit von entsprechenden Mengen an Wasserstoff erfolgen. Das bedeutet, dass schon bei Beginn einer Abscheidung Wasserstoff vorliegen muss, damit ein kristallines Wachstum vorteilhaft von Anfang an erfolgen kann. Im Rahmen der Erfindung wurde ein Verfahren entwickelt, um bei insgesamt geringem Wasserstoffverbrauch von Beginn der Deposition an ausreichend Wasserstoff zur Verfügung zu stellen. Bei dem kontinuierlichen Verfahren werden vorteilhaft nur geringe Wasserstoffmengen eingesetzt. Vorteilhaft werden während des Abscheideprozesses statische Depositionsbedingungen eingestellt. Dies erfolgt u.a. durch eine geregelte Zu- und Abführung der entsprechenden Gase in und aus der Plasmakammer. Zu Beginn des Abscheidevorgangs hat sich insbesondere ein Verhältnis von reaktivem, siliziumhaltigem Gas zu Wasserstoff von kleiner 0,5, insbesondere von kleiner als 0,25 als vorteilhaft, herausgestellt. Als für diese Verfahren geeignetes reaktives, siliziumhaltiges Gas ist insbesondere Silan zu nennen. Höhere Silane, z. B. Disilan (Si₂H₆), Chlor- und Fluorsilane, z. B. SiCl₄ oder SiF₄, sowie deren höhere Formen und Mischformen z. B. Dichlorsilan (SiCl₂H₂) sind ebenfalls denkbar. Die Anregungsfrequenz für das Plasma ist kleiner als 50 MHz, insbesondere kleiner als 30 MHz. Bei der Abscheidung mit PECVD wird beispielsweise die Standardindustriefrequenz von 13,56 MHz eingesetzt.

Eine erste Ausführungsform des Verfahrens sieht vor, zunächst eine Mischung aus Wasserstoff und einem reaktiven siliziumhaltigen Gas, insbesondere Silan, als Anfangsbedingung innerhalb der Abscheidungskammer vorzulegen. Dies kann beispielsweise sowohl durch a) das kontinuierliche Durchströmen der Plasmakammer mit einer entsprechenden Gasmischung aus Silan und Wasserstoff erfolgen, oder aber auch b) durch ein einmaliges Fluten der zuvor evakuierten Plasmakammer mit einer Gasmischung. Gleichzeitig mit dem Plasmastart wird dann im Fall a) die Wasserstoffzufuhr gestoppt.

Im weiteren Verlauf wird nach dem Plasmastart das durch das Plasma dissoziierte und durch den Abscheidevorgang verbrauchte Silan durch kontinuierliche Zugabe in die Kammer ersetzt. Zur Aufrechterhaltung von statischen Druckbedingungen (Depositionsdruck) innerhalb der Plasmakammer wird dementsprechend jeweils eine entsprechende Menge der dort vorliegenden Gasmischung aus der Kammer abgeführt. In Anwesenheit von Wasserstoff erfolgt das mikrokristalline Wachstum der Siliziumschichten auf dem Substrat von Anfang an.

Da die einzustellenden, absoluten Gasflüsse von der jeweiligen Größe der Plasmakammer abhängen, werden im Rahmen dieser Erfindung die Gasflüsse jeweils auf die zu beschichtende Substratfläche bezogen. Die nach dem Plasmastart eingestellten Gasflüsse für das reaktive, siliziumhaltige Gas liegen vorteilhaft in dem Bereich zwischen 0,5 und 20 sccm/100 cm² Beschichtungsfläche, insbesondere in dem Bereich zwischen 0,5 und 5 sccm/100 cm² Beschichtungsfläche.

In einer alternativen Ausgestaltung des Verfahrens wird der das Substrat aufweisenden Plasmakammer kontinuierlich eine Mischung aus reaktivem, siliziumhaltigem Gas und Wasserstoff zugeführt. Das Plasma wird gestartet, und es erfolgt die wunschgemäße mikrokristalline Abscheidung des Siliziums auf dem Substrat. Auch hier wird zur Aufrechterhaltung der statischen Druckbedingungen innerhalb der Kammer jeweils eine entsprechende Menge der dort vorliegenden Gasmischung aus der Kammer abgeführt. Vorteilhaft werden sowohl der Gesamtgasfluss als auch das Verhältnis von reaktivem, siliziumhaltigem Gas zu Wasserstoff während der gesamten Abscheidung konstant gehalten. Typische Gesamtflüsse liegen in dem Bereich unter 20 sccm/100 cm² Beschichtungsfläche, insbesondere in dem Bereich unter 6 sccm/100 cm² Beschichtungsfläche. Das eingestellte Verhältnis von reaktivem, siliziumhaltigem Gas und Wasserstoff liegt dabei vorteilhaft in dem Bereich über 15 %, insbesondere über 19 %. Als besonders vorteilhaft haben sich ein Gesamtgasfluss von weniger als 10 sccm/100 cm² Beschichtungsfläche bei einer Depositionsrate >0,1 nm/s, von weniger als 50 sccm/100 cm² Beschichtungsfläche bei einer Depositionsrate >0,5 nm/s, von weniger als 100 sccm/100 cm² Beschichtungsfläche bei einer Depositionsrate >1 nm/s, und von weniger als 200 sccm/100 cm² Beschichtungsfläche bei einer Depositionsrate > 2 nm/s herausgestellt. Besonders gute Ergebnisse konnten erzielt werden, wenn dabei ein Gesamtgasfluss von weniger als 6 sccm/100 cm² Beschichtungsfläche bei einer Depositionsrate > 0,1 nm/s, von weniger als 30 sccm/100 cm² Beschichtungsfläche bei einer Depositionsrate >0,5 nm/s, von weniger als 60 sccm/100 cm² Beschichtungsfläche bei einer Depositionsrate >1 nm/s, und von weniger als 120 sccm/100 cm² Beschichtungsfläche bei einer Depositionsrate > 2 nm/s eingestellt wurde.

Es wird eine Silankonzentration oberhalb von 3 % bei einer Anregungsfrequenz von 13,56 MHz für das Plasma gewählt, insbesondere von oberhalb von 10 % für alle größeren Anregungsfrequenzen des Plasmas.

Das erfindungsgemäße Verfahren ermöglicht es, auf einfache Weise homogene, mikrokristalline Siliziumschichten herzustellen, die sich insbesondere für den Einsatz als Absorberschichten in Solarzellen als hervorragend geeignet herausgestellt haben. Dabei liegt das besondere Augenmerk auf der Möglichkeit mit diesem Verfahren auch in dem engen Prozessfenster, dass für Solarzellen mit hohem Wirkungsgrad notwendig ist, geeignete Schichten abzuscheiden.

### Spezieller Beschreibungsteil

Nachfolgend wird der Gegenstand der Erfindung anhand von drei Figuren sowie zwei Ausführungsbeispielen näher erläutert, ohne dass der Gegenstand der Erfindung dadurch beschränkt wird.

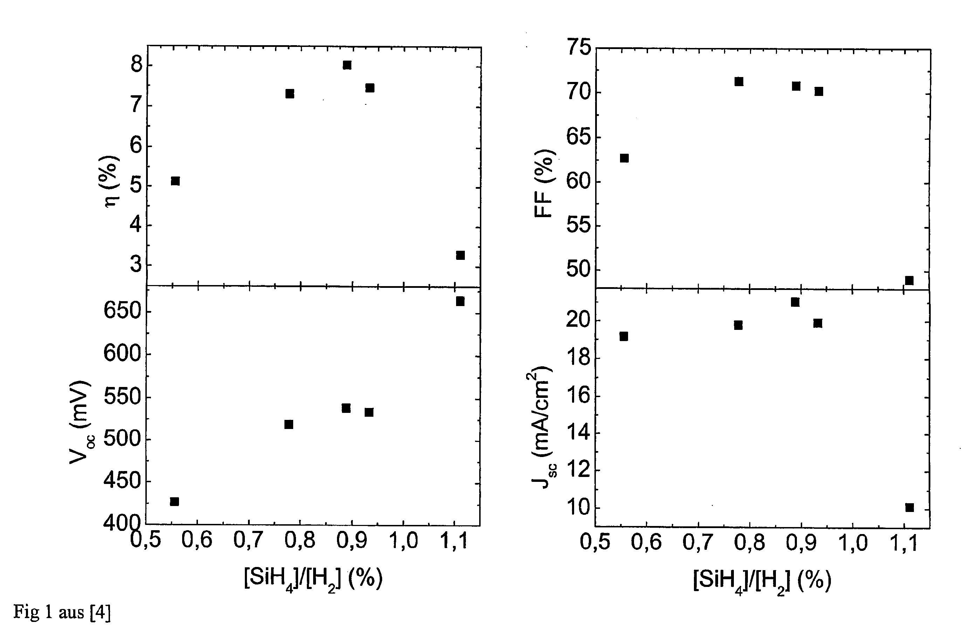

Es zeigen die
- Figur 1:: Die Solarzellenkenngrößen
a) Wirkungsgrad η,
b) Füllfaktor FF,
c) Leerlaufspannung V_{OC} und
d) Kurzschlussstromdichte J_{SC} jeweils in Abhängigkeit von der Silankonzentration [SiH₄]/[H₂].
   Die Solarzellen wurden bei einem Depositionsdruck p_{dep}=11 mbar und einer Plasmaleistung von P_{HF} = 0,26 W/cm² hergestellt und haben eine Absorberschichtdicke von ca. 1,1 *µ*m (nach Repmann^{[4]})
- Figur 2:: Silanfluss (Quadrate) und Silankonzentration (offene Dreiecke) für die Herstellung optimierter Solarzellen (entsprechend Figur 1) bei verschiedenen Wasserstoffflüssen. Die Solarzellen wurden bei 27 mbar und 0,7 W/cm² abgeschieden.
- Figur 3:: Quanteneffizienz einer Solarzelle mit 7,3 % Wirkungsgrad, deren i-Schicht ohne Zufuhr von Wasserstoff hergestellt wurde (Ausführungsbeispiel A).

Die Figur 1 erläutert das Verhalten der Solarzellenparameter bei Variation der Silankonzentration während des i-Schichtwachstums. Bei einer bestimmten Silankonzentration (hier: - 0,9 %) wird ein maximaler Wirkungsgrad erzielt. Diese Silankonzentration ist nicht nur für Solarzellen von Bedeutung, sondern ist gleichzeitig die höchste Silankonzentration bei der unter den gegebenen Bedingungen mikrokristallines Silizium mit hohem kristallinen Volumenanteil hergestellt werden kann.

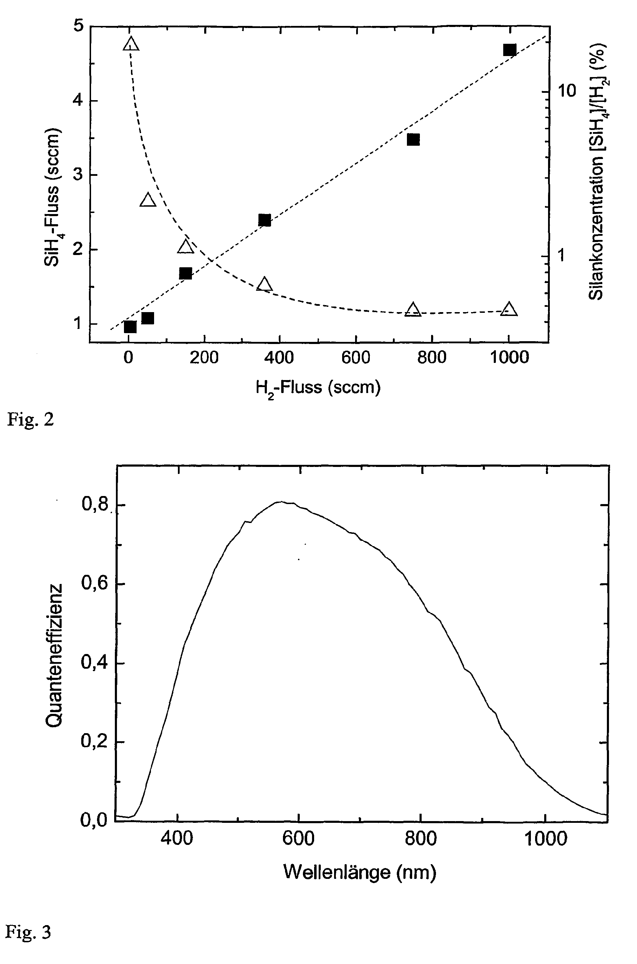

In der Figur 2 sind die maximalen Silanflüsse bei denen bei bestimmten Wasserstoffflüssen in einem kontinuierlichen Prozess mikrokristallines Wachstum erfolgen kann und die resultierenden Silankonzentrationen aufgetragen worden. Die Optimierung erfolgte gemäß Figur 1. Bei diesen Kombinationen aus Silan- und Wasserstoffflüssen ist bei dem angegebenen Druck und der angegebenen Leistung jeweils das homogene Wachstum mikrokristalliner Siliziumschichten (mit hohem kristallinen Volumenanteil) möglich.

Die Figur 3 zeigt die Quanteneffizienz einer Solarzelle bei der während der Deposition kein Wasserstoff mehr zugegeben wurde. Die hohe Quanteneffizient im langwelligen (> 800 nm) Spektralbereich zeigt, dass die i-Schicht einen hohen kristallinen Volumenanteil hat.

Nachfolgend werden zwei Ausführungsbeispiele für das erfindungsgemäße Verfahren näher beschrieben. Beide Ausführungsbeispiele beziehen sich jeweils auf eine Substratfläche von 100 cm².
A) In einer ersten Ausführungsform des Verfahrens wird eine Mischung aus Wasserstoff und Silan (entsprechend Standardprozessbedingungen, d. h. einem Silan-Wasserstoffgemisch gemäß Figur 2) eingesetzt, um vor dem Start der Deposition für definierte Anfangsbedingungen zu sorgen. Da von Anfang an Wasserstoff vorhanden ist, kann auch von Anfang an mikrokristallines Wachstum erfolgen. Nach dem Plasmastart wird der Wasserstofffluss abgeschaltet. Das verbrauchte Silan wird durch einen geringen Silanfluss ersetzt. Es ist die ganze Zeit Wasserstoff vorhanden, da einerseits der Wasserstoff der zu Beginn in der Kammer war nur zu einem geringen Teil verbraucht und abgepumpt wird, und andererseits durch die Deposition von Silizium aus Silan ständig neuer Wasserstoff entsteht (SiH₄ → Si(Schicht) + 2H₂). Dabei wird das Abpumpen die ganze Zeit so geregelt, dass der Depositionsdruck konstant bleibt. Eine Optimierung des Prozesses erfolgt dabei über die Wahl geeigneter Anfangsbedingungen und über die Wahl des Silanflusses während der Deposition. Der Prozess besteht also aus zwei Schritten:
   1. Aufbau des Depositionsdrucks bei hohem Wasserstofffluss und geringem Silanfluss (ohne Plasma).
   2. Deposition unter ausschließlichem Fluss von Silan.

   In dem gewählten Ausführungsbeispiel wurde bei p = 27 mbar eine Gasmischung mit dem Verhältnis [SiH₄]/[H₂] von 2,4 sccm/360 sccm in die Kammer eingeleitet. Mit dem Plasmastart (13,56 MHz Plasma) wurde die Zufuhr von Wasserstoff gestoppt. Der nach dem Plasmastart eingestellte Silanfluss betrug 1 sccm. Es erfolgte die Siliziumabscheidung auf dem Substrat bei einer Leistung von 0,7 W/cm². Die Dicke der abgeschiedenen Schicht betrug 1,8 µm bei einer Abscheidungsrate von 0,17 nm/s.
   Die mit diesem Verfahren hergestellte, vollständig mikrokristalline Schicht wurde erfolgreich in einer Solarzelle eingesetzt. Die so hergestellte Solarzelle hatte einen Wirkungsgrad von 7,3 % (FF = 62,6 %, V_{OC} = 490 mV, J_{SC} = 23,9 mA/cm²). In der Figur 3 ist die Quanteneffizienz der hergestellten Solarzelle gezeigt. Der hohe Kurzschlussstrom und die hohe Quanteneffizienz für Wellenlängen größer als 800 nm sind ein Hinweis auf den hohen kristallinen Volumenanteil über die ganze i-Schichtdicke hinweg. Setzt man für diese Zelle das verbrauchte Silan in Relation zu dem zum Druckaufbau verwendeten Wasserstoff, so kommt man auf ein Verhältnis von 4:3.
B) Bei einer weiteren Ausführungsform des Verfahrens wurde kontinuierlich ein Gemisch aus Silan und Wasserstoff als Prozessgas verwendet. Bei extrem niedrigen Gesamtgasflüssen führte die auftretende Silanverarmung dazu, dass mikrokristallines Wachstum auch bei niedrigen Wasserstoffflüssen erfolgte.
   Im gewählten Ausführungsbeispiel wurde bei den Depositionsbedingungen 1 sccm SiH₄, 4 sccm H₂, 27 mbar, 0,7 W/cm² eine Solarzelle mit einem Wirkungsgrad von 7,0 % (FF = 69,1 %, V_{oc}= 485 mV, 21,0 mA/cm² bei einer Depositionsrate von 0,24 nm/s hergestellt.

In dieser Anmeldung zitierte Literatur:
[1] A. V. Shah et al., Solar Energy Materials & Solar Cells, in print (2003)
[2] S. Koynov et al., Thin Solid Films 383 (2001) 206-208. S. Koynov et al., Jpn. J. Appl. Phys. 33 (1994) 4534-4539
[3] L. Feitknecht et al., Solar Energy Materials & Solar Cells, 74 (2002) 539-545
[4] T. Repmann et al., Proc. of the 28th IEEE Photovoltaic Specialists Conf., S. 912-915 (2000)

## Patentansprüche

1. Verfahren zur Abscheidung von mikrokristallinem Silizium auf einem Substrat in einer Plasmakammer bei dem:
a) die Plasmakammer vor dem Start des Plasmas ein reaktives, siliziumhaltiges Gas und Wasserstoff aufweist,
b) das Plasma gestartet wird,
c) der Kammer nach dem Plasmastart kontinuierlich ausschließlich reaktives, siliziumhaltiges Gas zugeführt wird oder der Kammer nach dem Plasmastart kontinuierlich ein Gemisch aus einem reaktiven, siliziumhaltigen Gas und Wasserstoff zugeführt wird wobei die Konzentration an reaktivem, siliziumhaltigen Gas bei der Zufuhr in die Kammer größer als 3 % eingestellt wird und
d) gleichzeitig das in der Kammer vorliegende Gasgemisch wenigstens teilweise aus der Kammer abgeleitet wird,
e) wobei der in die Plasmakammer eingeleitete Gesamtfluss an Gasen [sccm], bezogen auf die zu beschichtende Fläche des Substrates [100 cm²] in Relation zu der Abscheidungsrate [nm/s] einen Wert von 1 [sccm*s/(cm²*nm)], insbesondere von 0,6 [sccm*s/(cm²*nm)] nicht überschreitet,
f) eine Anregungsfrequenz für das Plasma kleiner 50 MHz, insbesondere kleiner 30 MHz gewählt wird, wobei ein Depositionsdruck größer als 3 mbar, insbesondere größer als 6 mbar eingestellt wird.

2. Verfahren nach Anspruch 1,
bei dem die Flüsse der der Kammer zugeführten und aus der Kammer abgeleiteten Gase bzw. Gasmischungen derart geregelt werden, dass sich während des Verfahrens ein konstanter Depositionsdruck ausbildet.

3. Verfahren nach einem der Ansprüche 1 bis 2,
bei dem das reaktive, siliziumhaltige Gas und der Wasserstoff vor dem Plasmastart in einem Verhältnis kleiner 0,5, insbesondere kleiner als 0,25 vorliegen.

4. Verfahren nach einem der Ansprüche 1 bis 3,
bei dem als reaktives, siliziumhaltiges Gas Silan eingesetzt wird.

5. Verfahren nach einem der vorhergehenden Ansprüche 1 bis 4,
bei dem der Kammer nach dem Plasmastart kontinuierlich ausschließlich reaktives, siliziumhaltiges Gas in einem Volumenstrom von 0,5 sccm bis zu 20 sccm/100 cm² Beschichtungsfläche, insbesondere von 0,5 sccm bis zu 5 sccm/100 cm² Beschichtungsfläche, zugeführt wird.

6. Verfahren nach einem der Ansprüche 1 bis 5,
bei dem Absorberschichten für Solarzellen mit einem Wirkungsgrad von mehr als 5 % hergestellt werden.

## Claims

1. Method for depositing microcrystalline silicon on a substrate in a plasma chamber in which:
a) the plasma chamber has a reactive silicon containing gas and hydrogen before the plasma start,
b) the plasma is started,
c) the chamber is supplied continuously and exclusively with a reactive silicon containing gas after the plasma start or the chamber is supplied continuously with a mixture of a reactive silicon containing gas and hydrogen after the plasma start, in which the concentration of the reactive silicon containing gas is set at more than 3%, when supplied to the chamber and
d) at the same time at least part of the gas mixture in the chamber is taken out of the chamber,
e) in which the total flow of gases introduced into the plasma chamber [sccm] with reference to the surface of the substrate to be covered [100 cm²] does not exceed a value of 1 [sccm*s/(cm²*nm)], particularly 0.6 [sccm*s/(cm²*nm)], in relation to the deposition rate [nm/s],
f) an excitation frequency for the plasma is selected, which is less than 50 MHz, particularly less than 30 MHz, in which a deposition pressure is set, which is greater than 3 mbar, particularly greater than 6 mbar.

2. Method according to claim 1,
in which the flows of gases or gas mixtures supplied to and taken out of the chamber are regulated in such a way that a constant deposition pressure is formed during the process.

3. Method according to one of claims 1 to 2,
in which the reactive silicon containing gas and the hydrogen are in a ratio, which is less than 0.5, particularly less than 0.25, before the plasma start.

4. Method according to one of claims 1 to 3,
in which silane is used as a reactive silicon containing gas.

5. Method according to one of the previous claims 1 to 4,
in which the chamber is supplied continuously and exclusively with a reactive silicon containing gas after the plasma start in a volume flow of 0.5 sccm to 20 sccm/100 cm² covering surface, particularly from 0.5 sccm to 5 sccm/100 cm² covering surface,

6. Method according to one of claims 1 to 5,
in which absorber layers for solar cells are produced with an efficiency of more than 5%.

## Revendications

1. Procédé de dépôt de silicium microcristallin sur un substrat dans une chambre à plasma, dans lequel :
a) la chambre à plasma a, avant l'amorçage du plasma, un gaz réactif silicié et de l'hydrogène,
b) on amorce le plasma,
c) on envoie dans la chambre, après l'amorçage du plasma, en continu, exclusivement du gaz réactif silicié ou on envoie à la chambre, après l'amorçage du plasma, en continu, un mélange d'hydrogène et d'un gaz réactif silicié, la concentration de gaz réactif silicié lors de l'envoi dans la chambre étant réglée à plus de 3 %,
d) on évacue en même temps de la chambre, au moins en partie, le mélange gazeux présent dans la chambre,
e) dans lequel le flux total de gaz [cm³ dans les conditions normales] introduit dans la chambre à plasma, rapporté à la surface à revêtir du substrat [100 cm²], en liaison avec la vitesse [nm/s] de dépôt ne dépassant pas 1 [cm³ dans les conditions normales*s/ (cm²*nm)], notamment 0,6 [cm³ dans les conditions normales*s/(cm²*nm)],
f) on choisit une fréquence d'excitation du plasma plus petite que 50 MHz, notamment plus petite que 30 MHz, en établissant une pression de dépôt supérieure à 3 mbars, notamment supérieure à 6 mbars.

2. Procédé suivant la revendication 1,
dans lequel on règle les flux des gaz et mélanges gazeux envoyés dans la chambre et évacués de la chambre de manière à former une pression de dépôt constante pendant le procédé.

3. Procédé suivant l'une des revendications 1 à 2,
dans lequel le gaz réactif silicié et l'hydrogène sont présents avant l'amorçage du plasma en un rapport plus petit que 0,5, notamment plus petit que 0,25.

4. Procédé suivant l'une des revendications 1 à 3,
dans lequel on utilise un silane comme gaz réactif silicié.

5. Procédé suivant l'une des revendications précédentes 1 à 4,
dans lequel on envoie à la chambre, après l'amorçage du plasma, en continu, exclusivement du gaz réactif silicié en un courant en volume de 0,5 cm3 dans les conditions normales à 20 cm3 dans les conditions normales/100 cm2 de surface de revêtement, notamment de 0,5 cm3 dans les conditions normales à 5 cm3 dans les conditions normales/100 cm2 de surface de revêtement.

6. Procédé suivant l'une des revendications 1 à 5,
dans lequel on fabrique des couches d'absorbeur pour des piles solaires ayant un rendement de plus de 5 %.
